# EUROPEAN PATENT SPECIFICATION

(11) **EP 4 151 945 B1**
(45) Date of publication and mention of the grant of the patent: **04.06.2025**
(21) Application number: 21197755.8
(22) Date of filing: 20.09.2021
(51) Int. Cl.: F28F 3/02, H01L 23/34, F28F 3/04, F28F 13/02, F28F 13/08

(54) **HEAT SINK DEVICE AND MANUFACTURING METHOD FOR A HEAT SINK FIN ELEMENT**
KÜHLKÖRPER UND HERSTELLUNGSVERFAHREN FÜR EIN KÜHLKÖRPERRIPPENELEMENT
DISPOSITIF DE DISSIPATEUR DE CHALEUR ET PROCÉDÉ DE FABRICATION D'UN ÉLÉMENT DE DISSIPATEUR DE CHALEUR À AILETTES

(43) Date of publication of application: 22.03.2023
(73) Proprietor: Rohde & Schwarz GmbH & Co. KG, 81671 München (DE)
(72) Inventor: Tan, Yin, 518139 Singapore (SG); Tiah, Elicia, 330053 Singapore (SG); Durai, Rajashekar, 509735 Singapore (SG); Law, AhHock, 519285 Singapore (SG); Tey, Kyzer, 564588 Singapore (SG)
(74) Representative: Novagraaf Group

(56) References cited:
- DE-A1- 102015 205 902
- US-A1- 2008 066 888
- US-A1- 2009 321 056
- US-A1- 2014 151 010
- US-A1- 2021 125 898
- US-B1- 6 201 699

## Description

### TECHNICAL FIELD

The disclosure relates to a heat sink device and a method for manufacturing a heat sink fin element.

### BACKGROUND

In a wide variety of technical applications undesired heating occurs due to the operation of a technical device. Such technical devices can be electronic, but also mechanical devices.

Especially in context of electronic devices the performance increases steadily. However, with the increase of the performance of such technical devices often also the power losses and therefore undesired heating increases.

Such undesired heating can cause trouble as the devices need to be protected from overheating. This can affect up-times of technical devices, their maintenance, but also their operation conditions and environment.

It is therefore known to use cooling systems to regulate the temperature of a technical device to manage high power densities and/or thermal loads. However, as the performance of the technical devices increases, typically the performance of the cooling systems needs to increase as well. Therefore, there is a need for efficient cooling systems.

Thermal management of a technical device is often a major consideration during product development or layout. Subject of discussion is often what amount of heat can be removed and how fast such heat can be removed from the technical device.

If the heat is removed by a fluid from the heat sink device, more powerful pumping units, pumping the fluid, are considered, e.g. in case of air as fluid more powerful fans. Also the surface areas of heat sink devices for heat exchange with the fluid can be increased. These factors affect the technical device in terms of form factor, cost, reliability and user experience.

Especially, more powerful pumping units have the disadvantage that in case of highperformance applications significant noise is generated which causes additional problems for the user of the technical device.

An exemplary cooling system is e.g. disclosed in US 5823249. The presented teaching uses fin elements with airfoil shape to avoid eddy currents trailing the airfoils which require input energy to the airflow and which do nothing to transfer heat from the airfoil to the flowing air.

US 2014/015 101.0 A1 discloses also a heat sink with a base having a structure side and an opposite environmental side. The structure side of the base is configured to thermally communicate with a structure for absorbing heat from the structure. A cooling fin extends a height outwardly from the environmental side of the base. The cooling fin extends a chord length along the base from a leading edge to a trailing edge of the cooling fin. The cooling fin includes the cross-sectional shape of an airfoil along at least a portion of the height of the cooling fin to increase the velocity of a flow of air along the cord length of the cooling fin.

WO 2020/232178 A1 concerns also a thermal management system which utilizes a fin in thermal contact with a heat pipe, wherein said fin comprises a fluid flow path in fluid communication with a first opening and a second opening of said fin, wherein said fluid flow path is configured to direct a second working fluid from said first opening to said second opening, wherein said first opening is oriented along a first direction of flow of said second working fluid towards said fin, and wherein said second opening is oriented along a second direction that is different than said first direction. Such fin can be configured as an airfoil.

Document US 2008 / 0 066 888 A1 discloses a heat sink that comprises a base panel and fins extending from the base panel, wherein the fins each comprise a cross-sectional configuration with two different radiuses, giving the fins a raindrop cross-sectional shape.

Document DE 10 2015 205 902 A1 discloses a method for manufacturing a heat sink fin element with a stamped part that has an airfoil cross-section.

Airfoil shapes of cooling fins have proven to be advantageous in connection with laminarly flowing fluids receiving the heat from the cooling fins. Due to the reduced flow resistance if the airfoil shape of the fin the amount of heat transfer between the fin and the working fluid is increased.

However, there is still a demand for a further improved heat sink device.

It is object of the invention to provide a heat sink device with improved cooling efficiency and a method for manufacturing a heat sink fin element for a heat sink device.

### SUMMARY

The above stated problem is solved by the features of the independent claims. It is understood that independent claims of a claim category may be formed in analogy to the dependent claims of another claim category. Further embodiments of the present disclosure are subject of the further dependent claims and of the following description, referring to the drawings.

Accordingly, the problem is solved by a heat sink device, comprising a base plate element, a first fin element arranged at the base plate element, whereas at least one out of the group of the base plate element, and the first fin element is configured to comprise an airfoil-shaped cross-section, whereas the base plate element comprises at least one bulge configured to generate vortices in a fluid flow passing the base plate element, characterized in that the base plate element comprises an airfoil-shaped cross-section extending from a leading edge to a trailing edge of the base plate element in a main flow direction.

By providing at least one bulge for the base plate element the heat exchange can be significantly increased between the heat sink device and a fluid passing the heat sink device. Such bulge is configured to generate vortices which cause a delayed flow separation and/or reduce the pressure drag. The bulges also have the effect to cause a pressure gradient directed towards the surface of the base plate element. This leads to an increased density of a compressible fluid close to the surface of the base plate element. These effects increase the amount of heat that can be transferred from the heat sink device to the fluid, respectively the fluid stream. The heat sink device is therefore configured to exchange heat with a fluid passing the heat sink device.

A fluid passing the base plate element means that the fluid is enabled to receive heat from the base plate element whereas while it passes the base plate element, especially the fluid is in direct contact with the base plate element.

Preferably, the fluid flow is laminar flowing towards the heat sink device and stays laminar besides the vortices generated by a bulge, respectively the plurality of bulges.

A term "bulge" shall be considered a physical structure configured to generate vortices in the fluid stream close to the base plate element surface. The bulge can be realized as protuberance, e.g. a protrusion or a outward dimple, but also as cavity, e.g. a recess or inward dimple, on the surface of the base plate element.

In embodiments, a second fin element may be arranged at the first fin element. The second fin element may also comprise an airfoil-shaped cross-section, while with a second fin element the first fin element not necessarily needs to comprise an airfoil-shaped cross-section.

Such bulges can in addition be comprised by the first fin element and/or second fin element, respectively by the surface of the first and/or second fin element, especially, if the first and/or second fin element has an airfoil-shaped cross-section.

Advantageously, the size and/or form of the bulge is adjusted to the used fluid and its Reynolds number. Further it is advantageous, if the bulge is configured to have a closed surface, i.e. the surface of the bulge is non-transparent for the fluid flow perpendicular to a main flow direction of the fluid.

The term "airfoil shaped cross-section" generally refers to a cross-section of a base plate element or a first or second fin element that generates a pressure differential and/or an aerodynamic force (e.g., a lift force) as a laminar fluid flows over it. Airfoil profiles can be implemented in common manufacturing technologies, e.g. sheet metal, milling or heatsink blazing. Examples of objects having an airfoil-shaped cross-section include a wing, a compressor rotor, a stator, a turbine blade, and/or a vane.

According to the disclosed heat sink device, the heat sink device can comprise a base plate element and a first fin element arranged on the base plate element. The heat sink device can also comprise a base plate element, a first fin element and a second fin element arranged at the first fin element, whereas the first fin element is attached at the base plate element. The heat sink device can also comprise a first fin element without second fin element and in addition a first fin element on which a second fin element is arranged. At least one of the base plate element, a first fin element and a second fin element, if any, shall be configured to have an airfoil-shaped cross-section.

At least one of the group of the base plate element, the first fin element and the second fin element shall be configured to have an airfoil-shaped cross-section. However, also more than one out of the group of the base plate element, the first fin element and the second fin element can be configured to have an airfoil-shaped cross-section. Especially, the base plate element can be configured to have an airfoil-shaped cross-section and the second fin element, if any, can be configured to have an airfoil-shaped cross-section. However, any combination of airfoil-based cross-sections from the group of the base plate element, the first fin element and the second fin element is considered comprised by the invention.

The base plate element and/or the fin element can be made from a material with high thermal conductivity, especially metal. The base plate element can be provided as a one-piece base plate element or can be assembled by several elements, which form together the base plate element.

The first fin element can be provided as a one-piece fin element or can be assembled by several elements, which form together the first fin element. The second fin element can be provided as a one-piece fin element or can be assembled by several elements, which form together the second fin element. Especially the second fin element can be a part of the first fin element.

It is advantageous, if the base plate element has a heat absorption surface, which is in thermal contact with a technical device to be cooled. The heat flow can be improved e.g. via a thermal paste. Such heat absorption surface or the surface of the technical device can be shaped such that the heat absorption surface fits a surface of the technical device to efficiently transfer heat from the technical device to the base plate element. It is especially advantageous, if the airfoil-shaped base plate element comprises a surface oriented towards to first fin element and a surface configured to be oriented towards a technical device and the surface configured to be oriented to the technical device has at least a planar section, especially is entirely planar.

This allows an easy thermal attachment of the technical device to the base plate element. Such fitting between the surface of the base plate element and the technical device can create a desired contact surface via a surface section through which the heat is transferred from the technical device to the base plate element, respectively to the heat sink device.

The surface oriented towards to the first fin element can also be called heat release surface, as it concerns the surface which releases heat from the base plate element to the fluid.

As fluid to receive the heat from the heat sink device a gaseous or liquid medium can be used. The fluid flow to the heat sink device is typically generated with a pumping unit, e.g. a fan or another appropriate fluid pump, known to the person skilled in the art. Due to the increased efficiency of the heat sink device the noise level generated by the pumping unit can be significantly reduced.

In case of air as fluid, the invention allows to reduce significantly the performance of a pumping unit for pumping the fluid, which provides reduced noise level without loss of performance for the heat sink. Further, the cooling can be provided cheaper and the pumping unit can be more compact and requires less space. Such heat sink device can be advantageously applied for oscilloscopes, power meters and voltmeters, especially for high performance applications.

The base plate element comprising an airfoil-shaped cross-section extending from a leading edge to a trailing edge of the base plate element in a main flow direction means that the fluid-dynamical advantages of such configuration are derived in the main flow direction of a fluid passing the base plate element. This leads to an increased transfer of heat from the base plate element to the fluid.

The leading edge is the edge of the base plate element which is arranged upstream to the trailing edge relative to the main flow direction. In other words, the leading edge is the upstream end of the base plate element, whereas the trailing edge is the downstream end of the base plate element. The main flow direction is the macroscopic flow direction of the fluid, which is also the direction in which the heat is transported after it has been received by the fluid.

In a further embodiment of the heat sink device the base plate element comprises a plurality of bulges configured to generate vortices in a fluid flow passing the base plate element, whereas the bulges comprised by the plurality of bulges are arranged behind each other in the main flow direction. This increases the effect on the delayed flow separation and therefore on the cooling efficiency.

Preferably, adjacent bulges of the plurality of bulges do not touch each other but are spatially separated from each other. The bulges arranged behind each other can have an offset perpendicular to the main flow direction. In an advantageous embodiment the plurality of bulges forms a straight line on the base plate element in main flow direction. The bulges can also be arranged such that a plurality of straight, especially parallel, lines is created by the bulges.

Such arrangement of a plurality of bulges increases the effect that the fluid is sucked into the direction of the base plate element which increases the possible heat transfer from the heat sink device to the fluid.

In a further embodiment the base plate element comprises a middle line defining the middle between the leading edge and the trailing edge, whereas the at least one bulge, especially the plurality of bulges, is arranged between the middle line and the trailing edge. Especially, the plurality of bulges can be preferably arranged in the last third of the base plate element or the last quarter of the base plate element in main flow direction. It was derived by simulations that such an arrangement of the plurality of bulges at the base plate element is highly advantageous to generate an increased heat transfer efficiency.

In another embodiment of the heat sink device, the a heat sink device comprises a base plate element, a first fin element arranged at the base plate element, whereas the first fin element is configured to comprise an airfoil-shaped cross-section, whereas the base plate element comprises a bulge configured to generate vortices in a fluid flow passing the base plate element, whereas the airfoil-shaped cross-section is arranged in a plane parallel to the main flow direction and parallel to the leading edge of the base plate. The first fin element can also comprise at least one bulge or a plurality of bulges.

In a further advantageous embodiment of the heat sink device, the first fin element is of a sheet-like shape defining a sheet plane, whereas the sheet plane is perpendicular to the leading edge and/or parallel to the main flow direction. A sheet-like shape shall be understood to be an essentially planar object which is significantly longer than thick and significantly wider than thick, which shall be considered a sheet. The width and length can vary for the sheet, i.e. the sheet-like shape is not restricted to rectangular or quadratic shapes. The first fin element needs not to extend from the leading edge to the trailing edge of the base plate element. However, it can extend, especially continuously. from the leading edge to the trailing edge of the base plate element. In case the first fin element extends to the leading edge of the base plate element, it is advantageous to increase the width, which might also be 7 considered to be the height from the first fin element, continuously from the leading edge to a constant value in certain distance from the leading edge in main flow direction. Such distance can e.g. be 1/20 to 1/5 of the length of the base plate element.

The sheet-like shaped first fin element is preferably made from thermally conductive material, e.g. metal, and arranged thermally conducting at the base plate element. This allows to distribute the heat absorbed from the technical device over the base plate element and the first fin element.

Such sheet-like shaped first fin element defines a sheet plane. The sheet plane is typically parallel to the main flow direction, which is also typically perpendicular to the leading edge of the base plate element. It may however be that the leading edge and the main flow direction are not perpendicular to each other. Then the arrangement of the sheet-like shaped first fin element can be oriented on the leading edge or the main flow direction. Preferably, the sheet plane of the sheet-like shaped first fin element is arranged orthogonal to the surface, respectively to the tangent plane in the respective point of the surface, of the base plate element. A sheet-like shaped first fin element increases the heat release surface of the heat sink significantly and further improves the efficiency of the heat sink device.

In a further embodiment of the heat sink device, a plurality of sheet-like shaped first fin elements is arranged parallel to the main flow direction and/or perpendicular to the leading edge, whereas adjacent first fin elements form a guiding channel for guiding a fluid flow in a main flow direction. A plurality of sheet-like shaped first fin elements means at least two; however preferably more than two first fin elements, can be utilized, e.g. 5, 6, 7, 8, 9, 10 or more. The plurality of sheet-like shaped first fin elements are typically arranged parallel to the main flow direction, which also means that the sheet-like shaped first fin elements are arranged parallel to each other, typically perpendicular to the leading edge and/or to the trailing edge of the base plate element. By the at least one guiding channel, especially a plurality of guiding channels, the fluid flow is laterally confined to the main flow direction and guided into the direction of the trailing edge.

In an advantageous embodiment the distance between adjacent sheet-like shaped first fin elements takes into account the size of the bulges, whereas the bulges take into account the properties of the fluid used for heat exchange. The distance of adjacent sheet-like shaped first fin elements can preferably be configured to be smaller than 4 times the diameter of a single bulge. This improves the fluid dynamics in the guiding channel.

It has been shown that in case of air used as fluid, an arrangement of three parallel straight lines of bulges, called subsequently bulge lines, extending in main flow direction within a guiding channel provide convincing results in terms of cooling efficiency. E.g. in each bulge line the distance between adjacent bulges is roughly the diameter of one bulge. The bulge lines adjacent to the first fin elements are arranged symmetrical to a center plane, arranged parallel to and in the middle between two adjacent first fin elements. The bulge line positioned in the center plane, i.e. symmetrically between the two outer bulge lines, has an offset to the outer two bulge lines in mass flow direction of roughly one bulge diameter.

Such plurality of sheet-like fin elements further increases the heat release surface of the heat sink and in addition stabilizes the fluid flow by means of the guiding channels. This further increases the heat transfer from the heat sink device to the fluid.

In a further embodiment of the heat sink at least one guiding channel extends to the leading edge, whereas the leading edge for the at least one guiding channel comprises a tubercle arranged symmetrically to a center plane of the guiding channel, whereas the center plane is oriented parallel to and arranged in the middle between the adjacent sheet planes. The tubercle is configured to disturb the incoming fluid flow in such controlled manner that the fluid flow over the airfoil is channeled into more narrow streams having higher velocities.

The tubercle is comprised by the leading edge of the base plate element. The tubercle can be a structure of the surface of the base plate element or a separate unit. Such structure can e.g. have a triangle-prism-like shape or a V-form-like shape and can be oriented with a tip or peak towards an incoming fluid stream. In such example the tip is arranged at the center plane. In addition, the triangle-prism-like shape can have varying thicknesses in main flow direction, but can also have varying thicknesses perpendicular to the main flow direction. E.g. at a selected position of the center plane, the tubercle can have its maximum thickness, whereas the thickness is reduced in direction towards the adjacent first fin elements. In main flow direction the thickness of the tubercle can continuously increase. The tubercle can also comprise a ridge at the position of the center plain supporting a channeling of the fluid flow. E.g. such form or shape of the tubercle leads to the desired effect which further increases the heat transfer from the heat sink device to the fluid.

Due to the tubercle the leading edge is typically only in some of its sections perpendicular the sheet planes of the sheet-like shaped first fin elements, however typically at these sections, where the leading edge is (at least virtually) cut by the first fin elements. In case reference is made to an arrangement perpendicular to the leading edge, the line connecting these sections shall be meant as leading edge, if not the entire leading edge, due to the presence of the tubercle, forms a straight line.

In a further embodiment of the heat sink device at least one guiding channel extends to the trailing edge, whereas the trailing edge for the at least one guiding channel comprises an end fin element arranged symmetrically to the center plane of the guiding channel, whereas the center plane is oriented parallel to and arranged in the middle between the adjacent sheet planes. The end fin element can be a structure of the surface of the base plate element. The end fin element comprised by the trailing edge can have a V form, whereas the end points of to two legs of the V contact the respective adjacent sheet-like shaped first fin elements. The tip of the end fin element can be arranged in main flow direction before the end points of the legs of the V with the adjacent sheet-like shaped first fin elements and is comprised by the center plane. The end fin element can be a separate unit or can be formed by the surface of the base plate element.

In a further advantageous embodiment of the heat sink, a plurality of bulges is arranged behind each other in the main flow direction within at least one guiding channel. Especially, it is advantageous, if there is a plurality of guiding channels, whereas each guiding channel comprises a plurality of bulges on the base plate element, which are configured generate vortices in a fluid flow passing the base plate element, whereas the bulges are arranged behind each other in the main flow direction within each of the plurality of guiding channels. Preferably, the plurality of bulges for each guiding channel are arranged between the middle line of the base plate element and the trailing edge of the base plate element. Especially in combination with the tubercles for each guiding channel and/or an end fin element for each guiding channel a very high efficiency for the heat transfer from the heat sink device to the fluid can be provided.

In another embodiment of the heat sink device, the base plate element comprises a leading edge and a trailing edge in a main flow direction, further comprising a second fin element, whereas the second fin element is arranged at the first fin element, whereas the second fin element is arranged such that it has an airfoil-shaped cross-section in a plane perpendicular to the leading edge and parallel to the main flow direction. This is especially of advantage, if the first fin element is configured to have a sheet-like shape. E.g. a plurality of second fin elements with such airfoil-shaped cross-section in a plane parallel to the sheet plane, can be used to further improve the efficiency of the heat sink device.

In another embodiment of the heat sink device, the base plate element comprises a leading edge and a trailing edge in a main flow direction, whereas at least one out of the group of the first fin element and the second fin element is configured to have an airfoil-shaped cross-section in a plane, which is parallel to the leading edge of the base plate element and parallel to the main flow direction. This means at least the first fin element or the second fin element shall be configured to comprise an airfoil-shaped cross-section in the defined plane. The base plate element is in this embodiment not required to have a certain shape, especially an airfoil-shaped cross-section, however the base plate element can comprise an airfoil-shaped cross-section as well. The airfoil-shaped cross-section of the first and/or second fin element shall be arranged in a plane, which is parallel to the leading edge of the base plate element and parallel to the main flow direction. It is advantageous, if the first and/or second airfoil shaped fin comprises at least one bulge, especially a plurality of bulges, at the first and/or second fin element to generate vortices in a fluid flow passing the first fin element and/or the second fin element. This provides another exemplary layout for a heat sink with high cooling efficiency.

In a further embodiment of the heat sink the first fin element is of a sheet-like shape defining a sheet plane, whereas the sheet plane is arranged perpendicular to the leading edge and/or perpendicular to the trailing edge of the base plate element, whereas the second fin element is arranged at the first fin element, whereas the second fin element has an airfoil-shaped cross-section in a plane, which is parallel to the leading edge of the base plate element and parallel to the main flow direction, whereas the second fin element is arranged partly outside of the sheet plane of the first fin element. Arranged partly outside of the sheet plane means that the fin element comprises a curved, i.e. a non-planar, section, whereas the second fin element is arranged such that one part of the second fin element is comprised by the sheet plane, another part of the second fin element is not comprised by the sheet plane.

It is especially advantageous, if a leading edge of the second fin element is attached to the first fin element and the trailing edge of the second fin element is positioned distant from the sheet plane of the first fin element. This allows an advantageous fluid flow close to the second fin element. The leading edge of the second fin element is still connected to the first fin element, and the trailing edge of the second fin element positioned away from the sheet plane. This provides a wing-like structure.

This layout allows also a new and easy way to manufacture a configuration for the first and second fin elements, whereas the efficiency of heat transfer is further increased. Further this embodiment allows a further increase of the heat release surface of the heat sink device, further increasing its cooling efficiency. A plurality of sheet-like shaped first fin elements can be used for a heat sink device, whereas one or more second fin elements are arranged at each of the first fin elements.

In a further embodiment of the heat sink, the first fin element comprises an opening, whose size corresponds to the size of the second fin element, whereas the opening comprises an upstream boundary area in main flow direction and a downstream boundary area in main flow direction, whereas the leading edge of the second fin element is part of the upstream boundary area. This describes an arrangement easy derivable by deforming a part of the first fin element, e.g. by cutting and pressing respective parts of the first fin element and by bending them out of the sheet plane. Such part becomes the second fin element. Through the opening in the first fin element derived from such processing fluid can flow to the surface of the second fin element directed to the sheet plane of the first fin element. This means that during operation the surface of the second fin element oriented away from the sheet plane and the surface oriented towards the sheet plane are in contact with the fluid. This is a favorable arrangement of the second fin element regarding the expectable fluid flow for the heat sink device. The second fin element can therefore be passed by the fluid on all sides as the fluid can reach the surface facing towards the first fin element through the opening of the first fin element. This allows a high cooling efficiency.

### BRIEF DESCRIPTION OF THE DRAWINGS

For a more complete understanding of the present disclosure and advantages thereof, reference is now made to the following description taken in conjunction with the accompanying drawings. The disclosure is explained in more detail below using exemplary embodiments which are specified in the schematic figures of the drawings, in which:
Figure 1 shows a schematic lateral view on a traditional heat sink device (prior art),
Figure 2 shows a schematic top view on a traditional heat sink device (prior art),
Figure 3 shows a schematic lateral view on a first exemplary embodiment of a heat sink device according to the invention,
Figure 4 shows a schematic top view on a first exemplary embodiment of a heat sink device according to the invention,
Figure 5 shows a schematic lateral view on a second exemplary embodiment of a heat sink device according to the invention,
Figure 6 shows a schematic top view on a second exemplary embodiment of a heat sink device according to the invention,
Figure 7 shows a schematic lateral view on a third exemplary embodiment of a heat sink device according to the invention,
Figure 8 shows a perspective view on a selected section of a fourth exemplary embodiment of a heat sink device according to the invention
Figure 9 shows a perspective view on a selected section of a fifth exemplary embodiment of a heat sink device according to the invention
Figure 10 shows a flow chart for an embodiment of a manufacturing method according to the invention.

In the figures like reference signs denote like elements unless stated otherwise.

### DETAILED DESCRIPTION OF THE DRAWINGS

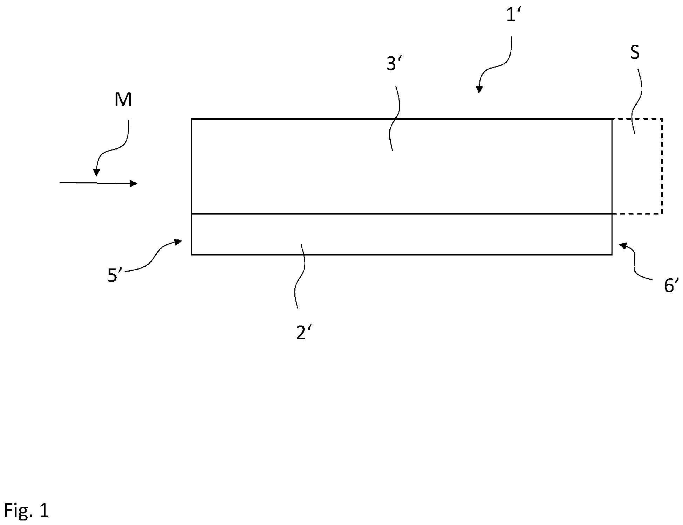

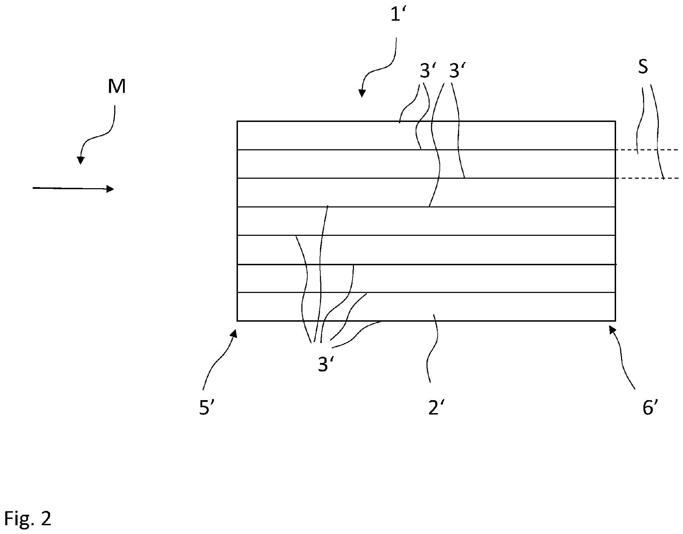

Figure 1 shows a lateral view of a traditional heat sink device 1'. The heat sink device 1 comprises a base plate element 2'. The base plate element 2' has a rectangular cross-section perpendicular to the lateral viewing direction of Figure 1. On the base plate element 2' a plurality of planar parallel first fin elements 3' is arranged, whereas in Figure 1 only a first fin element 3' is visible in viewing direction. Further planar fin elements 3' are arranged behind the visible first fin element 3' in lateral viewing direction (see Figure 2).

Figure 1 shows a main flow direction M. The main flow direction M gives the direction in which a fluid is flowing and transporting heat received from the heat sink device 1', when the heat sink device 1' is in operation.

The base plate element 2' of the heat sink device 1' comprises edges. The edge of the base plate element 2' positioned upstream relative to the main flow direction M is the leading edge 5' of the base plate element 2'. The edge of the base plate element 2' positioned downstream relative to the main flow direction M is the trailing edge 6'

of the base plate element 2'. The leading edge 5' and the trailing edge 6' are arranged perpendicular to the main flow direction M.

Below the base plate element 2', a technical device to be cooled, not shown in Figure 1, can be positioned in thermal contact with the surface of the base plate element 2' opposite to the side where the first fin element 3' is arranged.

Figure 2 shows the heat sink device 1' of Figure 1 from a top view. Here the plurality of planar first fin elements 3' is visible. Adjacent first fin elements 3' form a guiding channel for the fluid in main flow direction M.

During operation the technical device, not shown in Figure 1, generates heat loss. This heat generated by the technical device is transferred to the heat sink device 1', i.e. also the base plate element 2' and the planar first fin elements 3'.

By providing a fluid flow passing the heat sink device 1', the heat energy is transferred from the heat sink device 1' to the fluid and transported away in main flow direction M.

A fluid flow passing the heat sink device 1' shall mean that the fluid is guided such that it can receive thermal energy from the heat sink device. Especially the fluid can be in contact with the heat sink device 1'.

A heat sink device 1' according to Figure 1 and Figure 2 is used as reference configuration to show the performance of a heat sink device according to the invention.

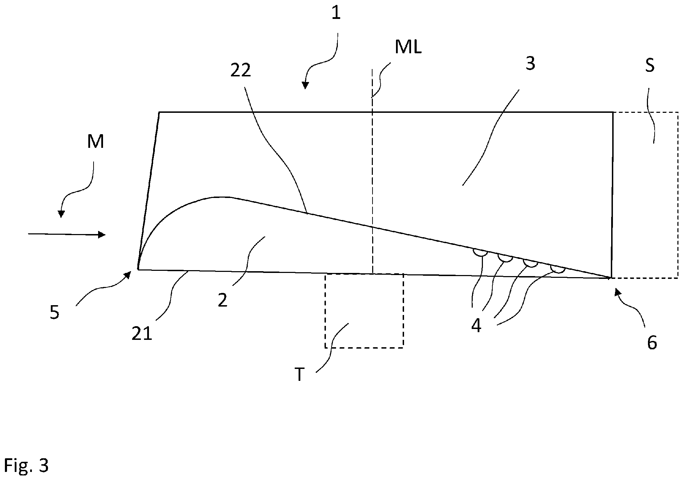

Figure 3 shows a lateral view on an exemplary heat sink device 1 according to the invention.

The heat sink device 1 comprises a base plate element 2 having an airfoil shape cross-section in a plane perpendicular to the lateral viewing direction. Further, the heat sink device 1 comprises a plurality sheet-like shaped first fin elements 3, whereas only the first sheet-like shaped first fin element 3 in lateral viewing direction is visible in Figure 3. In main flow direction M the base plate element 2 comprises a leading edge 5 and a trailing edge of the base plate element 2. The leading edge 5 that is the part of the base plate element 2 which gets first in contact with a fluid that streams in main flow direction M. The trailing edge 6 is the part of the base plate element 2, which is last in contact with the fluid that stream in main flow direction. The airfoil-shaped cross-section of the base plate element 2 is therefore also arranged in a plane perpendicular to the leading edge 5 and the trailing edge 6 of the base plate element 2.

The leading edge 5 and the trailing edge 6 can be defined by a line, e.g. as in Figure 3, or by a plane, e.g. in Figure 1. In Figure 3 the line defining the leading edge 5 and the trailing 6 edge are each and both parallel to the lateral viewing direction. In other words, the leading edge 5 and the trailing edge 6 are positioned perpendicular to the sheet-like shaped first fin element 3 defining a sheet plane S.

In Figure1 the plane defined by the leading edge 5' as well as the plane defined by the trailing edge 6' is parallel to the lateral viewing direction, respectively perpendicular to the sheet plane S of the sheet-like shaped first fin element 3.

Preferably, the airfoil shape of the base plate element 2 is configured such that the surface 21 opposite to the surface 22, where the first fin elements 3 are arranged, is at least partly planar. Preferably, the entire surface 21 of the base plate element 2 arranged opposite to the surface 22 of the base plate element comprising the plurality of first fin elements 3 is configured planar. This means that the so-called chord line, the shortest line between the leading edge and the trailing edge, is comprised by the surface 21 of the base plate element 2 directed away from the first fin elements 3.

This has the advantage that a desired contact area between the base plate element 2 and a technical device T to be cooled can be provided in an easy way. This allows a high amount of heat transfer from the technical device T to the heat sink device 1 in an easy way.

The first sheet-like shaped first fin element 3 rises from the leading edge 5 in an inclined way to given height, respectively width. According to Figure 3, it can be a linear inclination. However, also a non-linear inclination is possible. The amount of the inclination can be varied as well. In a special embodiment the height of the sheet-like shaped first fin element 3 is held constant in main flow direction M relative to the surface 22 of the base plate element 2 directed towards the first fin elements 3.

In addition, the heat sink device 1 comprises a plurality of bulges 4. Each bulge 4 is configured according to Figure 3 to have a are half-spherical recess, whereas the recess surface is part of the surface 22 of the base plate element 2 directed towards the plurality of first fin elements 3. However, the bulges 4 can also be shaped differently.

The bulges 4 are arranged behind each other in main flow direction M, preferably in regular patterns, especially in equal distances. The bulges 4 can be arranged as patterns also in a lateral direction at the base plate element 2.

In Figure 3, a middle line ML is shown, which is the middle between the leading edge 5 and the trailing edge 6 of the base plate element 2. The plurality of bulges 4 is arranged between the middle line ML and the trailing edge 6.

The size of the bulges 4 is selected such that in view of a selected fluid the bulges 4 create - during operation of the heat sink device 1 - vortices in a fluid flow passing the base plate element 2, whereas the bulges 4 are configured such that the vortices create for the given fluid flow an additional force pressing the fluid flow towards the surface 22.

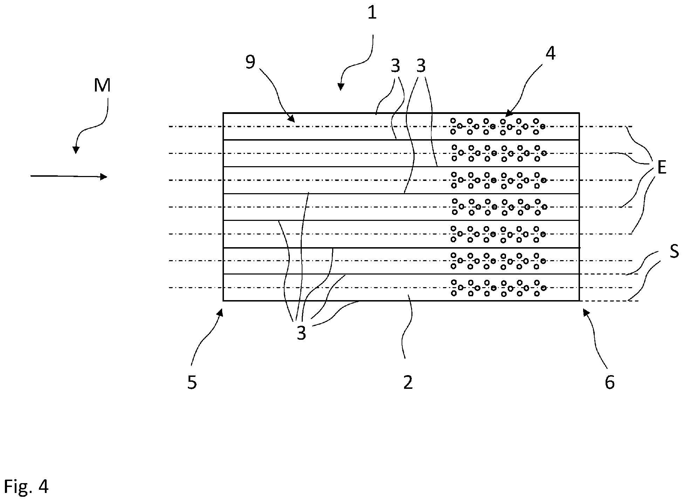

Figure 4 shows a top view of the heat sink device 1 shown in Figure 3. The plurality of sheet-like shaped first fin elements 3 can be seen from the top view. The sheet-like shaped first fin elements 3 are arranged parallel to each other and are perpendicular to the line defined by the leading edge 5 and trailing edge 6.

Adjacent sheet-like shaped first fin elements 3, respectively the sheet planes S defined by the sheet-like first fin elements 3, define a guiding channel 9 in which the fluid is confined laterally. Each guiding channel 9 comprises a plurality of bulges 4, whereas the plurality of bulges 4 are arranged symmetrically to a center plane E of a guiding channel 9. The center plane E is arranged in the middle between two adjacent sheet-like shaped first fin elements 3 and parallel to the two adjacent sheet-like shaped first fin elements 3.

In operation the fluid flows in main flow direction M towards the heat sink device 1, whereas a laminar flow is provided to the heat sink device 1. The airfoil shaped cross-section of the base plate element 2 leads to a stationary flow on the surfaces 22, 21 of the base plate element 2.

While the stationary fluid flow on the surface 22 of the base plate element 2 the bulges 4 generate vortices which lead to an increased fluid, especially air, density close to the surface 22. This enables a significant increase of heat transfer from the heat sink device 1 to the fluid.

Arranging the bulges 4 between the middle line ML of the base plate element 2 and the trailing edge 6 delays the flow separation for the base plate element 2, especially from the surface 22 in that area providing a better contact of the fluid to the surface 22 of the base element 2.

In case gas, especially air, is used as fluid for such heat sink device, the diameter of the bulges is advantageously 1/5 to 1/2 of the width of the guiding channel 9.

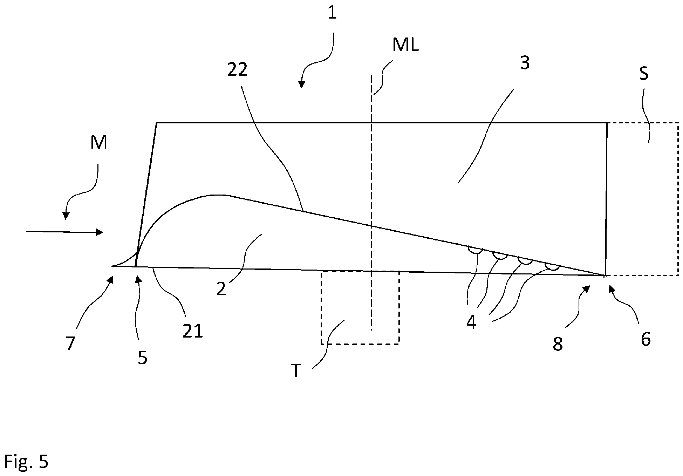

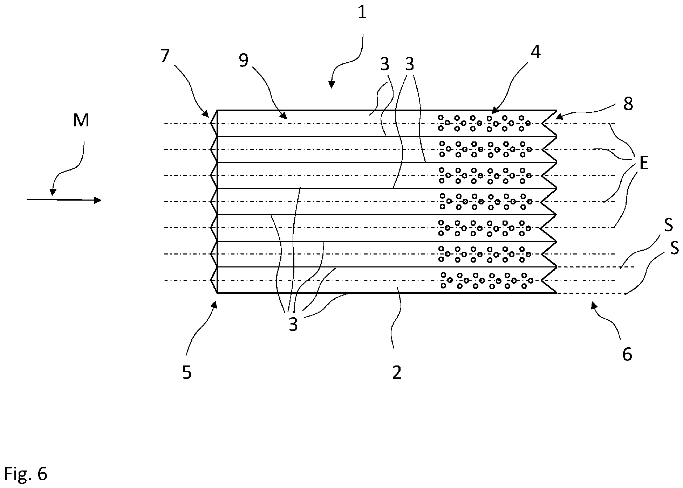

Figure 5 and Figure 6 show a further improved version of the heat sink device 1 shown in Figure 3 and 4. In addition to the features already described in context of Figure 3 and 4, Figure 5 shows a lateral view and Figure 6 a top view of a heat sink device 1 comprising a tubercle 7 for each guiding channel 9 and an end fin element 8 for each guiding channel 9.

The tubercles 7 and the end fin elements 8 are placed symmetrically to the center plane E. The tubercles 7 can preferably be comprised by the base plate element 2 or can be a separate unit arranged at the base plate element 2. Also, the end fin elements 8 can be comprised by the base plate element 2 or can be arranged at the base plate element 2 as separate unit.

The tubercles 7 create a controlled disturbance of the fluid flow when the fluid flow flows on the tubercle 7, i.e. before the airfoil shaped cross-section of the base plate element is reached. Each tubercle 7 creates vortices that generate a higher fluid density close to the surface 22 of the base plate element 2, especially in the respective guiding channel 9 following the tubercle 7 in main flow direction M. By the tubercles 7 further fluid channels are generated for the respective guiding channel 9, which increase the capacity of the fluid to receive heat energy from the base plate element 2. This further improves the cooling efficiency of the heat sink device 1.

The end fin elements 8 have the function to guide the fluid flow at the leading edge efficiently away from the heat sink device 1 and to avoid turbulences close to the heat sink device 1 and lead away the heated fluid in an efficient way from the base plate element 2.

Both, the tubercles 7 was well as the end fin elements 8 provide each a contribution to the cooling efficiency of the heat sink device 1.

Such a heat sink device 1 according to Figure 5 and 6 provides a decreased junction temperature of a diode (used as technical device) of roughly 15% compared to a heat sink device 1' according to Figure 1 and 2 under comparable conditions. The ambient temperature was 45 degree Celsius. As technical device a Diode TO-247 was used with a thermal conductance of 0.8K/W and a maximum junction temperature of 175 degree Celsius. The power dissipation was 2.0Watt, the heat sink device was made from Aluminum, whereas the air flow was generated with a Fan Sunon PE60251BX. The junction temperature of the diode for a heat sink device 1' according to Figure 1 and 2 is 129,2 degree Celsius. The junction temperature of the diode for a heat sink device 1 according to Figure 5 and 6 is 110,2 degree Celsius This shows a drastically improved cooling efficiency of the heat sink device 1 according to the invention compared to the heat sink device 1' according to Figure 1 or Figure 2.

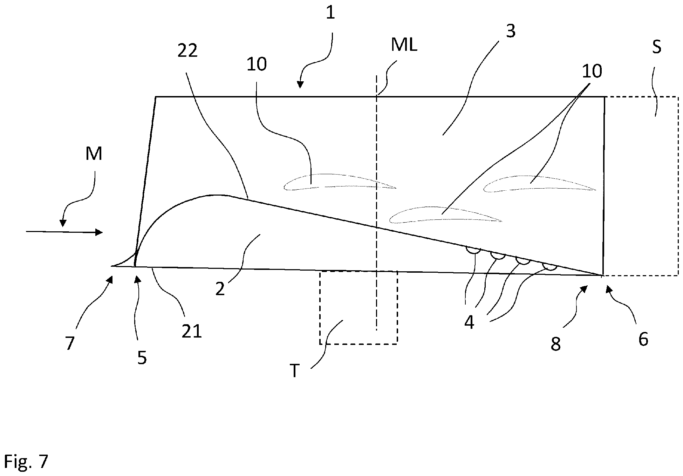

Figure 7 shows a further modified exemplary embodiment of a heat sink device according to the invention in a lateral view. In addition to the heat sink device 1 shown in Figure 5 and 6, the heat sink device 1 according to Figure 7 further comprises second fin elements 10. The second fin elements 10 are arranged at the first fin elements 3 in different distances from the surface 22 of the base plate element 2 and can be arranged behind each other in main flow direction M.

These second fin elements 10 have an airfoil cross-section in a plane parallel to sheet plane S of a sheet-like shaped first fin element 3, respectively in a plane perpendicular to the leading edge 5 and the trailing edge 6.

The second fin elements 10 can comprise bulges similar to the bulges 4 of the base plate element 2. The second fin elements 10 improve the heat exchange between the heat sink device 1 for fluid streams more distant from the base plate element 2.

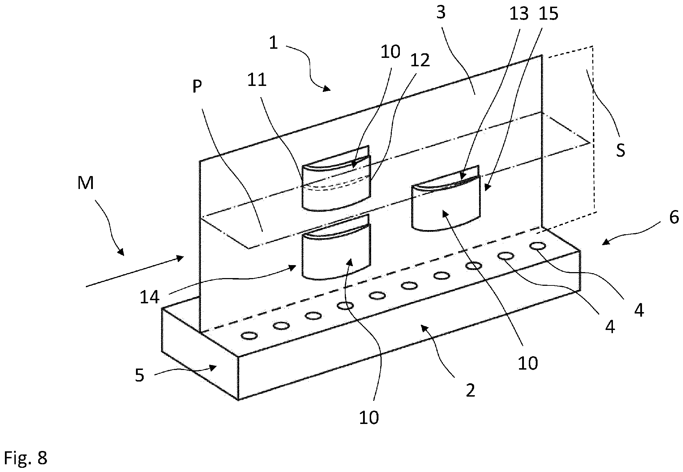

Figure 8 shows a section of an alternative configuration for a heat sink device 1 according to the invention. The shown section of the heat sink device 1 comprises a base plate element 2 on which a sheet-like shaped first fin element 3 is arranged. On the base plate element 2 a plurality of first fin elements 10 can be arranged. The shown sheet-like shaped first fin element 3 extends from the leading edge 5 to the trailing edge 6.

In a plane perpendicular to the leading edge 5, respectively parallel to the sheet plane S of the sheet-like shaped first fin element 3, the base plate element 2 has a rectangular cross-section. The surface 22 of the base plate element 2 oriented towards the first fin element 3 comprises a plurality of bulges arranged behind each other in main flow direction M.

Further, second fin elements 10 are arranged at the shown first fin element 10. In contrast to Figure 7, the second fin element 10 are arranged such that they have an airfoil shaped cross-section in a plane P perpendicular to the sheet plane S of the sheet-like shaped first in element 3, and parallel to the main flow direction Respectively this plane P is parallel to the surface 21 of the base plate element 2 facing away from the first fin elements 3.

The second fin elements 10 can comprise one or more bulges that generate vortices in a fluid passing the second fin element 10 to generated a delayed flow separation also at second fin elements 10.

A plurality of such arranged second fin elements 10 can be arranged at a first fin element 3, respectively at the plurality of first fin elements 10.

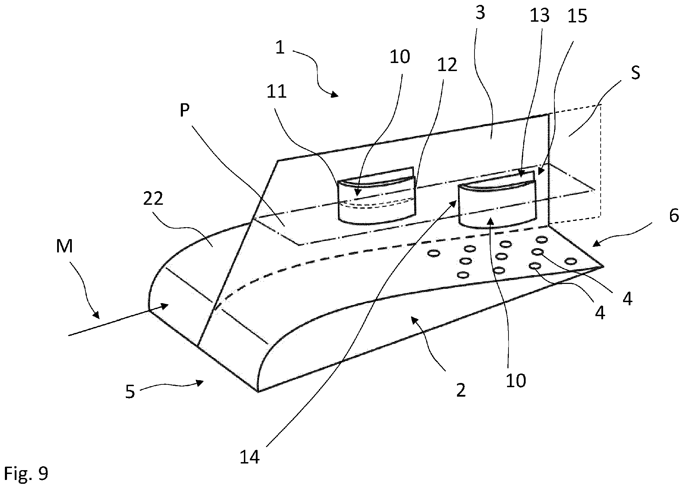

The sheet-like shaped first fin element 3 according to Figure 9 comprises an opening 13, whose size essentially corresponds to the size of the second fin element 10. The opening 13 comprises an upstream boundary area 14 and a downstream boundary area 15 relative to the main flow direction M. The leading edge of the second fin element is part of the upstream boundary area of the opening 13. Such configuration enables a good fluid flow on both sides of the second fin element 10 and therefore an efficient cooling.

In a further embodiment of a heat sink according to Figure 9, the first and second fin elements 3, 10, as shown in Figure 8, can be arranged at a base plate element 2 with an airfoil shaped cross-section in a plane parallel to the sheet-like shaped first fin element 3. The base plate element 2 comprises a plurality of bulges 4 between the middle of the base plate element 2 and the trailing edge 6.

With such configuration the heat can be exchanged to the fluid passing the heat sink element efficiently in different distances from the surface 22 of the base plate element. Close to the surface 22 a major share of the heat is transferred from the base plate element 2 to the fluid. As the fluid as more distance to the base plate element 2 more heat is transferred from the first and second fin element 3, 10 to the fluid, whereas an efficient fluid flow around the first fin element 3 and the second fin element 10 can be provided. Especially, each of the second fin elements 10 can comprise bulges to delay the flow separation for each second fin element to further improve the heat transfer to the fluid.

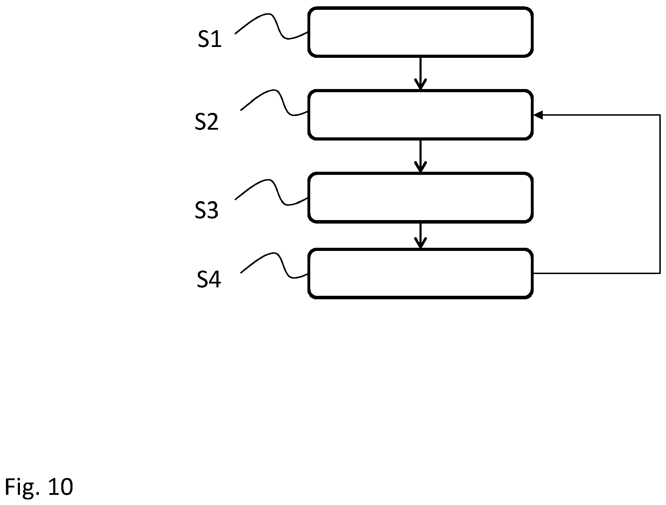

Figure 10 shows a flow chart for a manufacturing method for a heat sink fin element. Such heat sink fin elements can be applied for the section of heat sink devices shown in Figure 8 and 9.

In a first method step S1 a metal sheet with a sheet plane is provided to a stamper unit. This metal sheet will be at a later stage the first fin element.

In a next method step S2, as a first step of stamping, a rectangular part of the metal sheet is cut with the stamper unit, whereas the part is still attached to the metal sheet. E.g. three sides of the rectangular part can be cut and one side, especially the side arranged upstream to the main flow direction, is still attached to the metal sheet. The cut part can also have other forms than a rectangular form. The cut part will become the second fin element.

In a method step S3 the cut part is pressed, as part of the stamping, such by the stamper unit that the cut part receives an airfoil-shaped cross-section configured to be in a plane perpendicular to the sheet plane and parallel to the main flow direction when installed in a heat sink device. In addition, also bulges can be generated on the surface of the cut part, which is supposed to face away from the sheet plan from which it originates.

In a next method step S4 the cut and stamped part is formed with the stamper unit such that the part is partly arranged outside the sheet plane and partly inside the sheet plane. In addition, the cut and stamped part comprises a leading edge and a trailing edge in a main flow direction, whereas the cut and stamped part is stamped such that the leading edge is attached to the sheet and the trailing edge is arranged distant from the sheet plane.

In consequence a first fin element is generated comprising at least one second fin element having an airfoil-shaped cross-section in a plane perpendicular to the sheet plane and parallel to a later main flow direction.

The method steps S2 to S4 can be repeated for different positions of the metal sheet until a desired number of second fin elements have been manufactured for a first fin element. Advantageously, a plurality of second fin elements is created, especially in parallel, on and from the metal sheet. The method steps S2 to S4 can also be changed in its order or summarized into one or more steps.

The metal sheet, especially a plurality of metal sheets, comprising such stamped second fin elements can be arranged on a base plate element, especially a base plate element comprising an airfoil-shaped section.

Such stamped second fin elements in conjunctions with the opening of the first fin element provide an advantageous fluid flow for a heat sink device comprising such first and second fin elements. These heat sink fin elements are easy to manufacture and significantly improve cooling efficiency for a heat sink device.

Although specific embodiments have been illustrated and described herein, should be appreciated that the exemplary embodiment or exemplary embodiments are only examples, and are not intended to limit the scope, applicability, or configuration in any way. Rather, the foregoing summary and detailed description will provide those skilled in the art with a convenient road map for implementing at least one exemplary embodiment, it being understood that various changes may be made in the function and arrangement of elements described in an exemplary embodiment without departing from the scope as set forth in the appended claims Generally, this application is intended to cover any adaptations or variations of the specific embodiments discussed herein.

### LIST OF REFERENCE SIGNS

- 1': heat sink device according to prior art
- 2': base plate element: rectangular shaped cross-section
- 3': planar first fin element
- 5': leading edge of the base plate element with rectangular shaped cross-section
- 6': trailing edge of the base plate element with rectangular shaped cross-section

- 1: heat sink device
- 2: base plate element: airfoil shaped cross-section
- 3: first fin element: sheet like
- 4: bulge
- 5: leading edge of the base plate element
- 6: trailing edge of the base plate element
- 7: tubercle
- 8: end fin
- 9: guiding channel
- 10: second fin element
- 11: leading edge of the second fin element
- 12: trailing edge of the second fin element
- 13: opening
- 14: upstream boundary area
- 15: downstream boundary area

- M: main flow direction
- S: sheet plane
- P: plane parallel to the main flow direction and parallel to the leading edge

- S1:: providing a metal sheet with a sheet plane to a stamper unit
- S2:: cutting a rectangular part of the metal sheet with the stamper unit, whereas cut part is still attached to the metal sheet
- S3: stamping the cut part such with the stamper unit that it receives an airfoil-shaped cross-section
- S4: forming the cut and stamped part with stamper unit such that it is partly arranged outside the sheet plane, whereas the cut and stamped part comprises a leading edge and a trailing edge in a main flow direction, whereas the cut and stamped part is stamped such that the leading edge is attached to the sheet and the trailing edge is arranged distant from the sheet plane.

## Claims

1. Heat sink device (1), comprising a base plate element (2), a first fin element (3) arranged at the base plate element (2), whereas at least one out of the group of the base plate element (2), and the first fin element (3) comprises an airfoil-shaped cross-section, whereas the base plate element (2) comprises at least one bulge (4) configured to generate vortices in a fluid flow passing the base plate element (2);
**characterized in that**
the base plate element (2) comprises an airfoil-shaped cross-section extending from a leading edge (5) to a trailing edge (6) of the base plate element (2) in a main flow direction (M).

2. Heat sink device according to claim 1,
whereas the base plate element (2) comprises a plurality of bulges (4) configured to generate vortices in a fluid flow passing the base plate element (2), whereas the bulges comprised by the plurality of bulges (4) are arranged behind each other in the main flow direction (M).

3. Heat sink device according to claim 1 or 2,
whereas the base plate element (2) comprises a middle line (ML) defining the middle between the leading edge (5) and the trailing edge (6), whereas the at least one bulge (4) is arranged between the middle line (ML) and the trailing edge (6).

4. Heat sink device according to claim 2 or 3,
whereas the first fin element (3) is of a sheet-like shape defining a sheet plane (S), whereas the sheet plane (S) is arranged perpendicular to the leading edge (5) and/or parallel to the main flow direction (M).

5. Heat sink device according to claim 4,
whereas a plurality of sheet-like shaped first fin elements (3) is arranged parallel to the main flow direction (M) and/or perpendicular on the leading edge (5), whereas adjacent sheet-like shaped first fin elements (3) form a guiding channel (9) for guiding a fluid flow in a main flow direction (M).

6. Heat sink device according to claim 5,
whereas at least one guiding channel (9) extends to the leading edge (5), whereas the leading edge (5) for the at least one guiding channel (9) comprises a tubercle (7) arranged symmetrically to a center plane (E) of the guiding channel (9), whereas the center plane (E) is oriented parallel to and arranged in the middle between adjacent sheet planes (S).

7. Heat sink device according to claim 5 or 6,
whereas at least one guiding channel (9) extends to the trailing edge (6), whereas the trailing edge (6) for the at least one guiding channel (9) comprises an end fin element (8) arranged symmetrically to the center plane (E) of the guiding channel (9), whereas the center plane (E) is oriented parallel to and arranged in the middle between adjacent sheet planes.

8. Heat sink device according to one of the claims 5 to 7,
whereas a plurality of bulges (4) is arranged behind each other in the main flow direction (M), whereas the plurality of bulges (4) is arranged within at least one guiding channel (9).

9. Heat sink device according to one of the preceding claims,
further comprising a second fin element (10), whereas the second fin element (10) is arranged at the first fin element (3), whereas the second fin element (10) is arranged such that it has an airfoil-shaped cross-section in a plane perpendicular to the leading edge (5) and parallel to the main flow direction (M).

10. Heat sink device according to claim 9,
whereas at least one out of the group of the first fin element (3) and a second fin element (10) arranged at the first fin element (3) is configured to have an airfoil-shaped cross-section in a plane (P), which is parallel to the leading edge of the base plate element (2) and parallel to the main flow direction (M).

11. Heat sink device according to claim 10,
whereas the first fin element (3) is of a sheet-like shape defining a sheet plane (S), whereas the sheet plane (S) is arranged perpendicular to the leading edge (5) and/or perpendicular to the trailing edge (6) of the base plate element (2), whereas the second fin element has an airfoil-shaped cross-section in a plane (P), which is parallel to the leading edge of the base plate element (2) and parallel to the main flow direction (M), whereas the second fin element (10) is arranged partly outside of the sheet plane (S) of the first fin element (3).

12. Heat sink device according to claim 11,
whereas a leading edge (11) of the second fin element (10) is attached to the first fin element (3) and the leading edge (12) of the second fin element (10) is positioned distant from the sheet plane (S).

13. Heat sink device according to one of the claims 10 to 12,
whereas the first fin element (3) comprises an opening (13), whose size corresponds to the size of the second fin element (10), whereas the opening (13) comprises an upstream boundary area (14) in main flow direction (M) and a downstream boundary area (15) in main flow direction (M), whereas the leading edge (5) of the second fin element (10) is part of the upstream boundary area (14).

## Patentansprüche

1. Kühlkörpervorrichtung (1), umfassend ein Grundplattenelement (2), ein an dem Grundplattenelement (2) angeordnetes erstes Rippenelement (3), wobei mindestens eines aus der Gruppe aus dem Grundplattenelement (2) und dem ersten Rippenelement (3) einen tragflächenförmigen Querschnitt aufweist, während das Grundplattenelement (2) mindestens eine Ausbuchtung (4) aufweist, die dazu konfiguriert ist, in einem an dem Grundplattenelement (2) vorbeiströmenden Fluidstrom Wirbel zu erzeugen;
**dadurch gekennzeichnet, dass**
das Grundplattenelement (2) einen tragflächenförmigen Querschnitt aufweist, der sich in einer Hauptströmungsrichtung (M) von einer Vorderkante (5) zu einer Hinterkante (6) des Grundplattenelements (2) erstreckt.

2. Kühlkörpervorrichtung nach Anspruch 1,
wobei das Grundplattenelement (2) eine Vielzahl von Ausbuchtungen (4) umfasst, die dazu ausgebildet sind, in einer an dem Grundplattenelement (2) vorbeiströmenden Fluidströmung Wirbel zu erzeugen, wobei die von der Vielzahl von Ausbuchtungen (4) umfassten Ausbuchtungen in der Hauptströmungsrichtung (M) hintereinander angeordnet sind.

3. Kühlkörpervorrichtung nach Anspruch 1 oder 2,
wobei das Grundplattenelement (2) eine Mittellinie (ML) umfasst, die die Mitte zwischen der Vorderkante (5) und der Hinterkante (6) definiert, wobei die mindestens eine Ausbuchtung (4) zwischen der Mittellinie (ML) und der Hinterkante (6) angeordnet ist.

4. Kühlkörpervorrichtung nach Anspruch 2 oder 3,
wobei das erste Rippenelement (3) eine blattartige Form aufweist, die eine Blattebene (S) definiert, wobei die Blattebene (S) senkrecht zur Vorderkante (5) und/oder parallel zur Hauptströmungsrichtung (M) angeordnet ist.

5. Kühlkörpervorrichtung nach Anspruch 4,
wobei eine Vielzahl blattförmiger erster Rippenelemente (3) parallel zur Hauptströmungsrichtung (M) und/oder senkrecht auf der Vorderkante (5) angeordnet ist, wobei benachbarte blattartig geformte erste Rippenelemente (3) einen Führungskanal (9) zum Führen einer Fluidströmung in einer Hauptströmungsrichtung (M) bilden.

6. Kühlkörpervorrichtung nach Anspruch 5,
wobei sich mindestens ein Führungskanal (9) bis zur Vorderkante (5) erstreckt, wobei die Vorderkante (5) für den mindestens einen Führungskanal (9) einen symmetrisch zu einer Mittelebene (E) des Führungskanals (9) angeordnete Wölbung (7) aufweist, wobei die Mittelebene (E) parallel zu benachbarten Blattebenen (S) ausgerichtet und mittig zwischen diesen angeordnet ist.

7. Kühlkörpervorrichtung nach Anspruch 5 oder 6,
wobei sich mindestens ein Führungskanal (9) bis zur Hinterkante (6) erstreckt, wobei die Hinterkante (6) für den mindestens einen Führungskanal (9) ein symmetrisch zur Mittelebene (E) des Führungskanals (9) angeordnetes Endrippenelement (8) aufweist, wobei die Mittelebene (E) parallel zu benachbarten Blattebenen ausgerichtet und mittig zwischen diesen angeordnet ist.

8. Kühlkörpervorrichtung nach einem der Ansprüche 5 bis 7,
wobei eine Vielzahl von Ausbuchtungen (4) in Hauptströmungsrichtung (M) hintereinander angeordnet ist, wobei die Vielzahl von Ausbuchtungen (4) innerhalb mindestens eines Führungskanals (9) angeordnet ist.

9. Kühlkörpervorrichtung nach einem der vorhergehenden Ansprüche, die ferner ein zweites Rippenelement (10) umfasst,
wobei das zweite Rippenelement (10) am ersten Rippenelement (3) angeordnet ist, wobei das zweite Rippenelement (10) so angeordnet ist, dass es in einer Ebene senkrecht zur Vorderkante (5) und parallel zur Hauptströmungsrichtung (M) einen tragflächenförmigen Querschnitt aufweist.

10. Kühlkörpervorrichtung nach Anspruch 9,
wobei mindestens eines aus der Gruppe des ersten Rippenelements (3) und eines am ersten Rippenelement (3) angeordneten zweiten Rippenelements (10) so konfiguriert ist, dass es einen tragflächenförmigen Querschnitt in einer Ebene (P) aufweist, die parallel zur Vorderkante des Basisplattenelements (2) und parallel zur Hauptströmungsrichtung (M) verläuft.

11. Kühlkörpervorrichtung nach Anspruch 10,
wobei das erste Rippenelement (3) eine blattartige Form aufweist, die eine Blattebene (S) definiert, wobei die Blattebene (S) senkrecht zur Vorderkante (5) und/oder senkrecht zur Hinterkante (6) des Basisplattenelements (2) angeordnet ist, wobei das zweite Rippenelement einen tragflächenförmigen Querschnitt in einer Ebene (P) aufweist, die parallel zur Vorderkante des Basisplattenelements (2) und parallel zur Hauptströmungsrichtung (M) verläuft, wobei das zweite Rippenelement (10) teilweise außerhalb der Blattebene (S) des ersten Rippenelements (3) angeordnet ist.

12. Kühlkörpervorrichtung nach Anspruch 11,
wobei eine Vorderkante (11) des zweiten Rippenelements (10) an dem ersten Rippenelement (3) befestigt ist und die Vorderkante (12) des zweiten Rippenelements (10) von der Blattebene (S) entfernt positioniert ist.

13. Kühlkörpervorrichtung nach einem der Ansprüche 10 bis 12,
wobei das erste Rippenelement (3) eine Öffnung (13) umfasst, deren Größe der Größe des zweiten Rippenelements (10) entspricht, wobei die Öffnung (13) einen in Hauptströmungsrichtung (M) stromaufwärtigen Begrenzungsbereich (14) und einen in Hauptströmungsrichtung (M) stromabwärtigen Begrenzungsbereich (15) aufweist, wobei die Vorderkante (5) des zweiten Rippenelements (10) Teil des stromaufwärtigen Begrenzungsbereichs (14) ist.

## Revendications

1. Dispositif de dissipation thermique (1), comprenant un élément de plaque de base (2), un premier élément d'ailette (3) agencé au niveau de l'élément de plaque de base (2), dans lequel au moins l'un du groupe de l'élément de plaque de base (2), et le premier élément d'ailette (3) comprend une section transversale en forme de profil aérodynamique, dans lequel l'élément de plaque de base (2) comprend au moins un renflement (4) conçu pour générer des tourbillons dans un écoulement de fluide passant par l'élément de plaque de base (2) ;
**caractérisé en ce que** l'élément de plaque de base (2) comprend une section transversale en forme de profil aérodynamique s'étendant à partir d'un bord d'attaque (5) jusqu'à un bord de fuite (6) de l'élément de plaque de base (2) dans une direction d'écoulement principale (M).

2. Dispositif de dissipation thermique selon la revendication 1,
dans lequel l'élément de plaque de base (2) comprend une pluralité de renflements (4) conçus pour générer des tourbillons dans un écoulement de fluide passant par l'élément de plaque de base (2), dans lequel les renflements compris dans la pluralité de renflements (4) sont agencés l'un derrière l'autre dans la direction d'écoulement principale (M).

3. Dispositif de dissipation thermique selon la revendication 1 ou 2,
dans lequel l'élément de plaque de base (2) comprend une ligne médiane (ML) définissant le milieu entre le bord d'attaque (5) et le bord de fuite (6), dans lequel l'au moins un renflement (4) est agencé entre la ligne médiane (ML) et le bord de fuite (6).

4. Dispositif de dissipation thermique selon la revendication 2 ou 3,
dans lequel le premier élément d'ailette (3) a la forme d'une feuille définissant un plan de feuille (S), dans lequel le plan de feuille (S) est agencé perpendiculairement au bord d'attaque (5) et/ou parallèlement à la direction d'écoulement principale (M).

5. Dispositif de dissipation thermique selon la revendication 4,
dans lequel une pluralité de premiers éléments d'ailette en forme de feuille (3) sont agencés parallèlement à la direction d'écoulement principale (M) et/ou perpendiculairement au bord d'attaque (5), dans lequel les premiers éléments d'ailette en forme de feuille adjacents (3) forment un canal de guidage (9) permettant de guider un écoulement de fluide dans une direction d'écoulement principale (M).

6. Dispositif de dissipation thermique selon la revendication 5,
dans lequel au moins un canal de guidage (9) s'étend jusqu'au bord d'attaque (5), dans lequel le bord d'attaque (5) pour l'au moins un canal de guidage (9) comprend un tubercule (7) agencé symétriquement par rapport à un plan central (E) du canal de guidage (9), dans lequel le plan central (E) est orienté parallèlement à et agencé au milieu entre des plans de feuille adjacents (S).

7. Dispositif de dissipation thermique selon la revendication 5 ou 6,
dans lequel au moins un canal de guidage (9) s'étend jusqu'au bord de fuite (6), dans lequel le bord de fuite (6) pour l'au moins un canal de guidage (9) comprend un élément d'ailette d'extrémité (8) agencé symétriquement par rapport au plan central (E) du canal de guidage (9), dans lequel le plan central (E) est orienté parallèlement à et agencé au milieu entre des plans de feuille adjacents.

8. Dispositif de dissipation thermique selon l'une quelconque des revendications 5 à 7,
dans lequel une pluralité de renflements (4) sont agencés les uns derrière les autres dans la direction d'écoulement principale (M), dans lequel la pluralité de renflements (4) sont agencés au sein d'au moins un canal de guidage (9).

9. Dispositif de dissipation thermique selon l'une quelconque des revendications précédentes, comprenant en outre un second élément d'ailette (10),
dans lequel le second élément d'ailette (10) est agencé au niveau du premier élément d'ailette (3), dans lequel le second élément d'ailette (10) est agencé de telle sorte qu'il a une section transversale en forme de profil aérodynamique dans un plan perpendiculaire au bord d'attaque (5) et parallèle à la direction d'écoulement principale (M).

10. Dispositif de dissipation thermique selon la revendication 9,
dans lequel au moins l'un du groupe du premier élément d'ailette (3) et un second élément d'ailette (10) agencé au niveau du premier élément d'ailette (3) est conçu pour avoir une section transversale en forme de profil aérodynamique dans un plan (P), qui est parallèle au bord d'attaque de l'élément de plaque de base (2) et parallèle à la direction d'écoulement principale (M).

11. Dispositif de dissipation thermique selon la revendication 10,
dans lequel le premier élément d'ailette (3) a la forme d'une feuille définissant un plan de feuille (S), dans lequel le plan de feuille (S) est agencé perpendiculairement au bord d'attaque (5) et/ou perpendiculairement au bord de fuite (6) de l'élément de plaque de base (2), dans lequel le second élément d'ailette a une section transversale en forme de profil aérodynamique dans un plan (P), qui est parallèle au bord d'attaque de l'élément de plaque de base (2) et parallèle à la direction d'écoulement principale (M), dans lequel le second élément d'ailette (10) est agencé en partie à l'extérieur du plan de feuille (S) du premier élément d'ailette (3).

12. Dispositif de dissipation thermique selon la revendication 11,
dans lequel un bord d'attaque (11) du second élément d'ailette (10) est fixé au premier élément d'ailette (3) et que le bord d'attaque (12) du second élément d'ailette (10) est positionné à distance du plan de feuille (S).

13. Dispositif de dissipation thermique selon l'une quelconque des revendications 10 à 12,
dans lequel le premier élément d'ailette (3) comprend une ouverture (13), dont la taille correspond à la taille du second élément d'ailette (10), dans lequel l'ouverture (13) comprend une zone limite amont (14) dans la direction d'écoulement principale (M) et une zone limite aval (15) dans la direction d'écoulement principale (M), dans lequel le bord d'attaque (5) du second élément d'ailette (10) fait partie de la zone limite amont (14).
